# EUROPÄISCHE PATENTANMELDUNG

(11) **EP 2 320 486 A2**
(43) Veröffentlichungstag der Anmeldung: **11.05.2011**
(21) Anmeldenummer: 10014232.2
(22) Anmeldetag: 03.11.2010
(51) Int. Cl.: H01L 35/30, F01N 5/02

(54) **Verbindung zwischen einem thermoelektrischen Element und einem Wärmetauscher**

(30) Priorität: 04.11.2009 DE 102009051950
(71) Anmelder: Benteler Automobiltechnik GmbH, 33102 Paderborn (DE)
(72) Erfinder: Richter, Björn, 33106 Paderborn (DE); Przybylski, Sven, 33104 Paderborn (DE)
(74) Vertreter: Ksoll, Peter

(57) **Zusammenfassung**

Die vorliegende Erfindung betrifft eine Verbindung (1) zwischen einem thermoelektrischen Element (2) und einem Wärmetauscher (3), wobei das thermoelektrische Element (2) außenseitig jeweils eine Keramikträgerschicht (4) aufweist und der Wärmetauscher (3) eine Wärmetauscherwandung (5) aufweist. Die Verbindung (1) zwischen den beiden Bauteilen wird dabei durch ein Wärmeleitmittel (6) hergestellt. Das Wärmeleitmittel (6) wird zwischen der Keramikträgerschicht (4) und der Wärmetauscherwandung (5) angeordnet und begünstigt einen hohen Wärmeübergang vom Wärmetauscher (3) in das thermoelektrische Element (2). An dem thermoelektrischen Element (2) entsteht somit eine Heiß- (2a) und eine Kaltseite (2b). Zwischen Heiß- (2a) und Kaltseite (2b) entsteht eine Temperaturdifferenz, durch die das thermoelektrische Element (2) eine Spannung erzeugt.

## Beschreibung

### Verbindung zwischen einem thermoelektrischen Element und einem Wärmetauscher

Die vorliegende Erfindung betrifft eine Verbindung zwischen einem thermoelektrischen Element und einem Wärmetauscher, wobei das thermoelektrische Element außenseitig eine Keramikträgerschicht aufweist und der Wärmetauscher eine Wärmetauscherwandung aufweist.

Aus dem Stand der Technik sind Abgaswärmerückgewinnungssysteme bekannt. Hierbei werden thermoelektrische Generatoreneinheiten in einem Abgasweg eines Verbrennungsmotors angeordnet, um Energie aus der von Abgasen mitgeführten Abgaswärme zurück zu gewinnen.

Bei den aus dem Stand der Technik bekannten Verfahren werden Thermoelemente in einem Abgasdurchlass angeordnet. Durch den Abgasstrom und die Verbindung des Abgasrohres zur Umgebung entsteht eine Temperaturdifferenz. Thermoelektrische Elemente wandeln mithilfe des Seebeck-Effekts die vorliegende Temperaturdifferenz direkt in elektrische Energie um.

Damit an dem thermoelektrischen Element eine Temperaturdifferenz auftreten kann, verfügt dieses über eine Heiß- und über eine Kaltseite. Um einen entsprechenden Temperaturgradienten im Betrieb des thermoelektrischen Elements halten zu können, ist eine entsprechende Dicke der einzelnen Elemente notwendig. Im Aufbau wird daher meistens eine Dünnschichttechnologie oder eine Folientechnik eingesetzt, die jedoch in einem Abgasstrang, in dem hohe Temperaturdifferenzen herrschen, nicht optimal arbeiten kann.

Um einen elektrischen Kurzschluss zu vermeiden und eine entsprechende mechanische Stabilität zu realisieren, wird die Ober- und Unterseite des thermoelektrischen Elements mithilfe von keramischen Platten fixiert. Durch die keramischen Platten werden dann auf der zum Abgasstrang hingewandten Seite eine Heißseite und auf der dem Abgasstrang abgewandten Seite eine Kaltseite gebildet.

Bei der Produktion einer Baugruppe mit thermoelektrischen Elementen werden die einzelnen Baugruppen direkt mit der Heiß- bzw. Kaltseite in das oder die umliegenden Bauteile gepresst und verspannt.

Im Bereich der Energierückgewinnung aus einem Abgasstrang im Kraftfahrzeug werden mehrere thermoelektrische Baugruppen miteinander verschaltet. Diese werden gleichmäßig auf eine plane Ebene eines einzelnen Bauteils gebracht. Um entsprechende Wärmeübergänge und gleichmäßige Verpressungen realisieren zu können, weisen die Oberflächen der einzelnen Bauelemente eine Oberflächengüte im Bereich von ca. 20 µm auf. Dadurch entsteht ein hoher Fertigungsaufwand, der mit einem hohen Kostenaufwand verbunden ist.

Auf der Seite des thermoelektrischen Generatorenmoduls ist es zusätzlich von Nachteil, dass die keramische Trägerschicht der Heiß- bzw. Kaltseite in Bezug auf die eingesetzte Werkstoffkomponenten eine geforderte Oberflächengüte größtenteils nicht aufweisen kann. Um dem entgegenzuwirken und im Rahmen der Fertigungstolleranzen konstant hohe Wärmeübergänge zu realisieren, werden die einzelnen Baugruppen mit hohem Druck verpresst und anschließend verspannt. Hierbei treten unzulässige Eigenspannungen in den einzelnen Bauteilen, insbesondere in den thermoelektrischen Elementen auf, die die Lebensdauer der Bauelemente entscheidend verringern.

Die Aufgabe der vorliegenden Erfindung ist es daher thermoelektrische Bauelemente mit einem Wärmetauscher zur Verfügung zu stellen, die eine gleichbleibend hohe Fertigungsqualität sowie einen einfachen Fertigungsprozess und einen hohen Wärmeübergang zur Verbesserung des Gesamtwirkungsgrads realisieren.

Die vorliegende Aufgabe wird durch eine Verbindung gemäß den Merkmalen des Patentanspruchs 1 gelöst. Daraus ergibt sich, dass zwischen der Keramikträgerschicht und der Wärmetauscherwandung ein Wärmeleitmittel angeordnet ist, welches die Keramikträgerschicht und die Wärmetauscherwandung stoffschlüssig verbindet.

Vorteilfhafte Ausgestaltungen und Weiterbildungen des grundsätzlichen Erfindungsgedankens sind Gegenstand der abhängigen Ansprüche 2 bis 9.

Durch diesen Lösungsansatz müssen thermoelektrische Elemente nicht mehr mit hohen Kräften angepresst werden, in der Folge werden unzulässige Eigenspannungen vermieden.

Durch die stoffschlüssige Verbindung wird ein gleichbleibend hoher Wärmeübergang zwischen der Keramikträgerschicht und der Wärmetauscherwandung durch das Wärmeleitmittel sichergestellt.

Ein weiterer Vorteil des Wärmeleitmittels ist, dass fahrzeugseitige Vibrationen, die durch den Betrieb des Verbrennungsmotors bzw. den Fahrbetrieb über die Straße auf das System übertragen werden, entsprechend gedämpft übertragen werden. Hierdurch erhöht sich ebenfalls die Dauerfestigkeit eines Systems mit thermoelektrischen Elementen.

Vorzugsweise ist das Wärmeleitmittel als homogene Wärmeleitungsschicht ausgebildet. Hierbei ist unter einer homogenen Wärmeleitungsschicht eine in allen Bereichen der Wärmeleitungsschicht gleichbleibende Molekülstruktur der eingesetzten Werkstoffe zu verstehen. An den Grenzübergängen von Keramikträgerschicht zu Wärmeleitungsschicht und Wärmeleitungsschicht zu Wärmetauscherwandung wird somit ein hoher Wärmeübergangskoeffizient erreicht.

In einer weiteren vorteilhaften Ausbildung weist das Wärmeleitmittel eine Wärmeleitfähigkeit von mehr als 10 W/mK auf. Die hohe Wärmeleitfähigkeit ermöglicht einen guten Wärmeabtransport, so dass während der gesamten Betriebsdauer stets eine Temperaturdifferenz in den thermoelektrischen Bauelementen gegeben ist. Die Temperaturdifferenz wiederum bedingt eine Spannungserzeugung auf Grund des Seebeck-Effekts.

Vorzugsweise ist das Wärmeleitmittel als Legierung ausgebildet, die Bestandteile von Gallium (Ga) und Indium (In) aufweist. Gallium und Indium können Verbindungen sowohl mit Edelstahl als auch mit Keramik und zusätzlich auch in sich eingehen. Ein Wärmeleitmittel, dass die zuvor genannten Legierungsbestandteile aufweist, geht in den Grenzzonen der Keramikträgerschicht und der Wärmetauscherwandung Verbindungen ein. Die Verbindungen sind in Form von Brückenbildungen über Sauerstoffatome, mechanischer Retention und Kaltdiffusion ausgebildet. Sie werden sowohl zur Anhaftung in den Grenzzonen als auch zur Wärmeleitung genutzt.

Im Gitter herrscht somit eine Mischbildung aus Atombindungs- und lonenbindungsanteilen und einem geringen metallischen Bindungsanteil.

Dabei sorgt Indium für eine geringe Oberflächenspannung und somit ein gutes Benetzungsvermögen für andere Metalle, Glas oder Keramikmassen. Es verzerrt die Gitter der Legierung und bewirkt dadurch eine Verbesserung der mechanischen Eigenschaften. Indium bildet ein gelbes Haftoxid, das zum Anhaften keramischer Massen an Metallen beiträgt. Hierbei trägt das Oxidationsverhalten wesentlich zum Metall-Keramik-Verbund bei.

Gallium senkt die Schmelztemperatur der Legierung und verbessert so zusätzlich die Fließfähigkeit und das Formfüllvermögen der Legierung.

In einer besonders bevorzugten Ausführungsvariante weist die Legierung zusätzlich Zinn (Sn) als Legierungsbestandteil auf. Zinn verringert die Kohlenstoffaufnahme und sorgt dafür, dass die zu verbindenden Stahllegierungen nicht entkohlt werden. Weiterhin fördert Zinn die Haftoxidbildung der Bestandteile Gallium und Indium. Hierdurch wird eine höhere Festigkeit mit den zuvor benannten Legierungsbestandteilen herbeigeführt.

Die Legierung weist bevorzugt einen Anteil von 60 - 80% Gallium, 10 - 30% Indium und 1 - 20% Zinn auf, sowie weitere Bestandteile von anderen Stoffen, zum Beispiel Wismut oder Antimohn. Die Legierungsbestandteile sind wichtig für die Einstellung einer bestimmten Schmelztemperatur. Die durch die Legierungsbestandteile hergestellten Werkstoffeigenschaften des Wärmeleitmittels müssen ebenfalls unter dem Aspekt der Verarbeitungstemperatur und des Betriebstemperaturbereichs ausgewählt werden. Galinstan oder Natrium werden dabei bevorzugt als Wärmeleitmittel eingesetzt.

Vorzugsweise ist die Wärmetauscherwandung aus einem metallischen Trägersubstrat ausgebildet.

Besonders bevorzugt besteht das Trägersubstrat aus einer austenitischen Edelstahllegierung. Das Abgas eines Fahrzeug weist korrosive Eigenschaften auf und ein breites Spektrum sowohl in seiner Zusammensetzung als auch in seinen Betriebstemperaturen. Ein metallischer Werkstoff, insbesondere eine Edelstahllegierung bietet daher eine besonders gute Schutzwirkung gegen Einflüsse durch das Abgas gepaart mit einer gleichbleibend guten und hohen Wärmeleitfähigkeit. Somit kann während des gesamten Spektrums von möglichen Betriebspunkten ein ausreichender Wärmeübergang aus dem Abgasstrom in das thermoelektrische Element begünstigt werden.

In einer weiteren bevorzugten Ausführungsvariante ist das Wärmeleitmittel als Lot ausgebildet. Für die Lötung ist eine entsprechend vollflächig metallisierte Keramikträgerschicht vorteilhaft. Weiterhin ist je nach Anwendungsgebiet der Einsatz verschiedener Lotverbindungen vorstellbar. Zum Beispiel kann ein Hartlot oder ein Weichlot in Bezug auf die jeweilige Einsatztemperatur verwendet werden oder aber auch ein Aktivlot, das bei einer hohen Einsatztemperatur eingesetzt werden kann. Hierbei wäre keine Metallisierung der Keramikträgerschicht zum Eingehen einer stoffschlüssigen Verbindung mit dem Lot notwendig.

Vorzugsweise ist das thermoelektrische Element als thermoelektrischer Generator ausgebildet. Der Generator besteht dabei aus einer Vielzahl von thermoelektrischen Elementen, die miteinander elektrisch in Reihe oder parallel verbunden sind. Um einen entsprechenden Temperaturgradienten zu erzeugen und im Betrieb halten zu können ist eine entsprechende Dicke der einzelnen Elemente notwendig. Der so aufgebaute thermoelektrische Generator weist an seiner Ober- und Unterseite keramische Trägerplatten auf, die dann eine Heiß- und eine Kaltseite ausbilden. Zwischen der Heiß- und Kaltseite entsteht die Temperaturdifferenz, die wiederum durch den Seebeck-Effekt eine elektrische Spannung erzeugt.

Weitere Vorteile, Merkmale, Eigenschaften und Aspekte der vorliegenden Erfindung ergeben sich aus der folgenden Beschreibung, bevorzugte Ausführungsformen anhand der schematischen Zeichnungen. Diese dienen dem einfacheren Verständnis der Erfindung.

Es zeigen:
- Figur 1: eine Prinzipskizze einer Verbindung eines thermoelektrischen Elements mit einem Wärmetauscher und
- Figur 2: eine Schnittdarstellung eines thermoelektrischen Generators.

In den Figuren werden für gleiche oder ähnliche Teile dieselben Bezugszeichen verwendet, wobei entsprechende oder vergleichbare Vorteile erreicht werden, auch wenn eine wiederholte Beschreibung aus Vereinfachungsgründen entfällt.

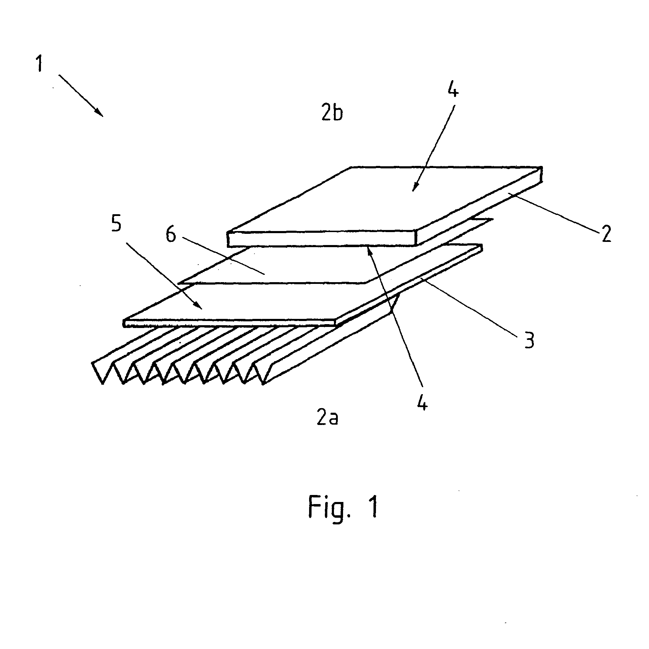

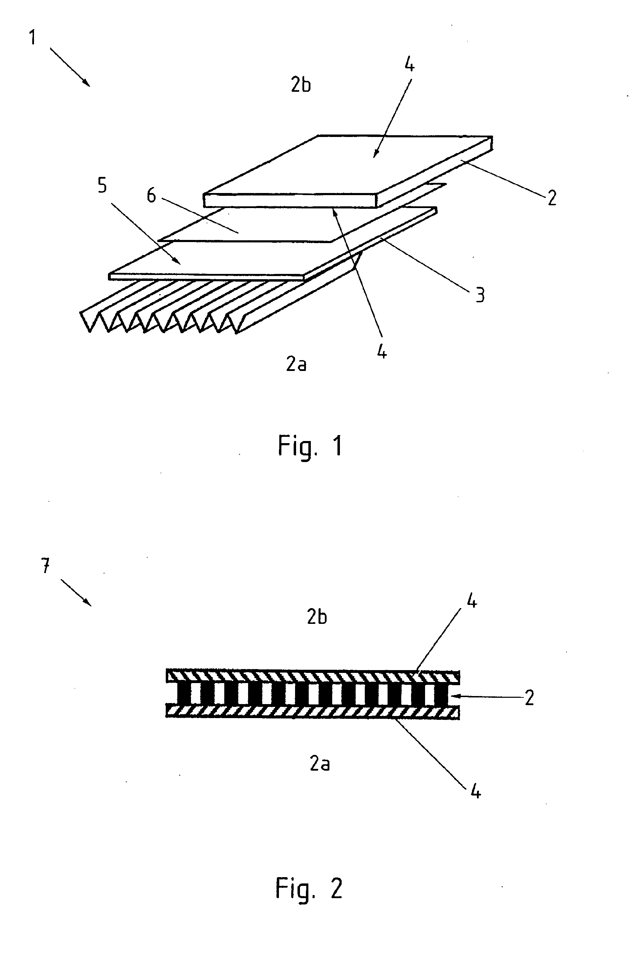

Figur 1 zeigt eine Verbindung 1 eines thermoelektrischen Elements 2 mit einem Wärmetauscher 3. Das thermoelektrische Element 2 weist außenseitig Keramikträgerschichten 4 auf. Bezogen auf die Bildebene bildet die Unterseite des thermoelektrischen Elements 2 dabei eine Heißseite 2a, die Oberseite des thermoelektrischen Elements 2 eine Kaltseite 2b. Der Wärmetauscher 3 ist mit einer Wärmetauscherwandung 5 ausgebildet. Die Wärmetauscherwandung 5 grenzt dabei an die Heißseite 2a des thermoelektrischen Elements 2 an. Zwischen der Wärmetauscherwandung 5 und der Keramikträgerschicht 4 der Heißseite 2a ist ein Wärmeleitmittel 6 angeordnet. Das Wärmeleitmittel 6 verbindet die Keramikträgerschicht 4 und die Wärmetauscherwandung 5 stoffschlüssig. Es bildet dabei eine homogene Wärmeleitungsschicht aus. Über die Wärmeleitungsschicht kann ein Wärmestrom von dem Wärmetauscher 3 in das thermoelektrische Element 2 übergehen.

Das Wärmeleitmittel 6 weist dabei bevorzugt die Legierungselemente Gallium (Ga), Indium (In) und Zinn (Sn) auf. Die so hergestellte Legierung geht Verbindungen mit der Wärmetauscherwandung 5 und mit der Keramikträgerschicht 4 ein. Die Wärmetauscherwandung 5 kann dabei als metallisches Trägersubstrat bzw. als austenitische Edelstahllegierung ausgebildet sein.

Figur 2 zeigt eine Schnittdarstellung durch einen thermoelektrischen Generator 7. Hierbei sind thermoelektrische Elemente 2 parallel oder in Reihe geschaltet miteinander verbunden. Die so verbundenen Elemente werden von zwei Keramikträgerschichten 4 begrenzt. Zwischen den Keramikträgerschichten 4 entsteht eine Temperaturdifferenz.

An einer Seite des thermoelektrischen Generators 7 entsteht durch die Applizierung im Betrieb eine Heißseite 2a und an der der Heißseite 2a gegenüberliegenden Seite eine Kaltseite 2b.

### Bezugszeichen:

1 - Verbindung
2 - thermoelektrisches Element
2a - Heißseite
2b - Kaltseite
3 - Wärmetauscher
4 - Keramikträgerschicht
5 - Wärmertauscherwandung
6 - Wärmeleitmittel
7 - thermoelektrischer Generator

## Patentansprüche

1. Verbindung (1) zwischen einem thermoelektrischen Element (2) und einem Wärmetauscher (3), wobei das thermoelektrische Element (2) außenseitig eine Keramikträgerschicht (4) aufweist und der Wärmetauscher (3) eine Wärmetauscherwandung (5) aufweist, **dadurch gekennzeichnet, dass** zwischen der Keramikträgerschicht (4) und der Wärmetauscherwandung (5) ein Wärmeleitmittel (6) angeordnet ist, welches die Keramikträgerschicht (4) und die Wärmetauscherwandung (5) stoffschlüssig verbindet.

2. Verbindung zwischen einem thermoelektrischen Element und einem Wärmetauscher nach Anspruch 1, **dadurch gekennzeichnet, dass** das Wärmeleitmittel (6) eine homogene Wärmeleitungsschicht ausbildet.

3. Verbindung zwischen einem thermoelektrischen Element und einem Wärmetauscher nach Anspruch 1 oder 2, **dadurch gekennzeichnet, dass** das Wärmeleitmittel (6) eine Wärmeleitfähigkeit von mehr als 10 W/mK aufweist.

4. Verbindung zwischen einem thermoelektrischen Element und einem Wärmetauscher nach einem der Ansprüche 1 bis 3, **dadurch gekennzeichnet, dass** das Wärmeleitmittel (6) eine Gallium (Ga) und Indium (In) enthaltende Legierung ist.

5. Verbindung zwischen einem thermoelektrischen Element und einem Wärmetauscher nach einem der Anspruch 4, **dadurch gekennzeichnet, dass** die Legierung zusätzlich Zinn (Sn) als Bestandteil aufweist.

6. Verbindung zwischen einem thermoelektrischen Element und einem Wärmetauscher nach einem der Ansprüche 1 bis 5, **dadurch gekennzeichnet, dass** die Wärmetauscherwandung (5) aus einem metallischen Trägersubstrat ausgebildet ist.

7. Verbindung zwischen einem thermoelektrischen Element und einem Wärmetauscher nach Anspruch 6, **dadurch gekennzeichnet, dass** das Trägersubstrat eine austenitische Edelstahllegierung ist.

8. Verbindung zwischen einem thermoelektrischen Element und einem Wärmetauscher nach einem der voranstehenden Ansprüche, **dadurch gekennzeichnet, dass** das Wärmeleitmittel (6) als Lot ausgebildet ist.

9. Verbindung zwischen einem thermoelektrischen Element und einem Wärmetauscher nach einem der voranstehenden Ansprüche, **dadurch gekennzeichnet, dass** das thermoelektrische Element (2) als thermoelektrischer Generator (7) ausgebildet ist.
